(19) Europäisches Patentamt
European Patent Office
Office européen des brevets

(11) **EP 1 664 813 B1**

(12) **EUROPÄISCHE PATENTSCHRIFT**

(45) Veröffentlichungstag und Bekanntmachung des Hinweises auf die Patenterteilung:
**31.10.2007 Patentblatt 2007/44**

(21) Anmeldenummer: 04762679.1

(22) Anmeldetag: **18.08.2004**

(51) Int Cl.:
***G01R 31/36*** (2006.01)

(86) Internationale Anmeldenummer:
**PCT/DE2004/001835**

(87) Internationale Veröffentlichungsnummer:
**WO 2005/026760 (24.03.2005 Gazette 2005/12)**

(54) **Verfahren und Schaltungsanordnung zur Bestimmung einer in einem Zeitraum verbrauchten ladung bei Mobilgeräten**

Method and circuit arrangement for determining a charge used during a specific period of time in mobile devices

Procédé et circuit pour determiner une charge utilisée par des appareils mobiles sur un intervalle de temps

(84) Benannte Vertragsstaaten:
**DE FR GB**

(30) Priorität: **09.09.2003 DE 10341549**

(43) Veröffentlichungstag der Anmeldung:
**07.06.2006 Patentblatt 2006/23**

(73) Patentinhaber: **Infineon Technologies AG
81669 München (DE)**

(72) Erfinder:
• **FELBECKER, Britta
81549 München (DE)**
• **HAMMES, Markus
46539 Dinslaken (DE)**
• **HELLFAJER, Roland
44869 Bochum (DE)**

(74) Vertreter: **Patentanwälte Lambsdorff & Lange
Dingolfinger Strasse 6
81673 München (DE)**

(56) Entgegenhaltungen:
**EP-A- 0 593 198       US-A- 5 065 084
US-B1- 6 236 214**

**Beschreibung**

Die Erfindung betrifft ein Verfahren und eine Schaltungsanordnung zum Berechnen einer verbrauchten Ladung Q bezogen auf einen Zeitraum $\Delta t$ in einem Mobilgerät mit netzunabhängiger Stromversorgung.

Um bei mobilen Geräten, die im Allgemeinen mit einer Batterie oder einem Akku betrieben werden, eine Vorausberechnung für die noch zu erwartende Betriebsdauer durchführen zu können, ist es bereits bekannt, die verbrauchte Ladung Q bezogen auf einen Zeitraum $\Delta t$ zu ermitteln.

Besonders in Mobilstationen digitaler Mobilfunksysteme ergeben sich während des Betriebs große Unterschiede hinsichtlich des jeweiligen Stromverbrauchs. Ursächlich dafür ist die stark unterschiedliche Leistungsaufnahme der Mobilstation in Abhängigkeit von dem Bestehen oder Nicht-Bestehen einer Funkübertragungsverbindung.

Um den Stromverbrauch berechnen zu können, bieten sich zwei Möglichkeiten an.

Eine erste Möglichkeit besteht darin, den Stromverbrauch des Mobilgerätes anhand einer Strommessung und Integration des Stromverlaufes über der Zeit zu ermitteln. Da der Stromverbrauch, wie oben erwähnt, sehr großen Schwankungen unterworfen ist, kann die Strommessung sehr aufwendig sein. Unter Umständen ist ein hochauflösender Analog-/Digital-Wandler erforderlich.

Eine zweite Möglichkeit, die bei paketorientierten Mobilfunksystemen wie beispielsweise Bluetooth anwendbar ist, besteht darin, den mittleren Stromverbrauch für verschiedene Pakettypen abzuspeichern. Bluetooth weist eine Vielzahl von Pakettypen für unterschiedliche Verbindungen (synchron/asynchron) und Aufgaben (Verbindungsaufbau, "Pollen" etc.) auf. Durch die Überwachung der ausgesendeten und empfangenen Pakettypen lässt sich durch Aufsummieren der Paket-bezogenen typischen Stromverbräuche auf die im Beobachtungszeitraum verbrauchte Ladung schließen. Dieses Verfahren weist jedoch die folgenden Nachteile auf:

1. Die Berechnung eines Schätzwertes für den tatsächlichen Stromverbrauch kann sehr aufwändig sein, weil sich der Paket-typische Ladungsverbrauch aus mehreren Anteilen zusammensetzt. Hierbei sind insbesondere konstante Anteile, beispielsweise ein Anteil, welcher mit einem Paketgebundenen Trägerfrequenz-Wechsel einhergeht, und variable Anteile, welche beispielsweise von der Anzahl der gesendeten Daten pro Paket abhängig sind, zu berücksichtigen.

2. Bei der Umrechnung des Stromverbrauchs bei einer zuvor abgespeicherten Datenrate auf eine aktuelle Datenrate können nicht vollständige Datenpakete oder auch eine nicht gleichmäßige Verteilung der Daten über die verschiedenen Zeitschlitze, wenn überhaupt, nur mit sehr hohem Aufwand berücksichtigt werden.

3. Wenn sich das System trotz konstanter Datenrate nicht periodisch verhält, kann dieser Einfluss keine Berücksichtigung bei der Berechnung des Stromverbrauchs finden. Das periodische Verhalten des Systems kann durch komplex ablaufende Softwareprozesse oder aber auch durch extern initiierte Ereignisse (Events) gestört werden.

Die oben genannten Nachteile sind ursächlich dafür, dass diese Methode relativ ungenau arbeitet.

Die Schrift US 5,065,084 beschreibt eine Chipkarte, die mit einem integrierten Schaltkreis ausgestattet ist. Der integrierte Schaltkreis wird von einer Batterie versorgt, deren Ladezustand überwacht werden soll. Hierfür werden die Arbeitstakte gezählt, mit welchen eine CPU des integrierten Schaltkreises getaktet wird. Aus dem erhaltenen Zählwert wird der Ladezustand der Batterie abgeschätzt.

Der Erfindung liegt die Aufgabe zugrunde, ein Verfahren zur Ermittelung des Stromverbrauchs eines Mobilgerätes anzugeben, welches hinreichend genau und aufwandsminimal arbeitet. Ferner zielt die Erfindung darauf ab, eine entsprechende Schaltungsanordnung mit den obigen Eigenschaften bereitzustellen.

Die der Erfindung zugrunde liegende Aufgabenstellung wird durch die Merkmale der unabhängigen Ansprüche gelöst.

Es wird darauf hingewiesen, dass der Begriff "verbrauchte Ladung Q bezogen auf einen Zeitraum $\Delta t$" sich sowohl als Ladungsänderung als auch als mittlere Stromaufnahme in einem Zeitraum $\Delta t$ interpretieren lässt und in dieser Schrift vereinfachend mit dem Begriff Stromverbrauch umschrieben wird.

Das erfindungsgemäße Verfahren zum Berechnen eines Stromverbrauchs in einer Mobilstation eines Mobilfunksystems mit netzunabhängiger Stromversorgung basiert auf verschiedenen möglichen Systemzuständen $s_k$, in welchen sich das Gerät in dem Beobachtungs-Zeitraum $\Delta t$ befinden kann. Die Systemzustände, in denen sich die Mobilstation befinden kann, umfassen einen Empfangs/Sendezustand, in welchem die Mobilstation im Empfangsbetrieb oder im Sendebetrieb arbeitet, oder alternativ einen Empfangszustand, in welchem die Mobilstation im Empfangsbetrieb arbeitet, und einen Sendezustand, in welchem die Mobilstation im Sendebetrieb arbeitet.

In einem ersten Schritt wird jeweils Systemszustands-abhängig ein Wert einer Größe $\Delta_k$ für im Zeitraum $\Delta t$ auftretende Systemzustände $s_k$ bestimmt, wobei die charakteristische Größe $\Delta_k$ die Zeitdauer $\Delta t_k$ eines Systemzustands $s_k$ in dem Zeitraum $\Delta t$ beschreibt. Die Größen $\Delta_k$ und $\Delta t_k$ können auch identisch sein. Dabei wird jeweils der Wert der

charakteristischen Größe $\Delta_k$ eines Empfangs/Sendezustands oder alternativ Empfangszustands oder Sendezustands derart bestimmt, dass die Anzahl der über den Zeitraum $\Delta t$ empfangenen und gesendeten bzw. empfangenen bzw. gesendeten Symbole oder Bits in dem jeweiligen Zustand bestimmt wird. Insbesondere mit Hilfe eines Zählers, welcher in Hardware oder Software implementiert ist, kann die Bestimmung der Anzahl der Symbole oder Bits durchgeführt werden. Handelt es sich bei dem Mobilfunksystem um ein CDMA-System (code division multiple access), bei dem jedes Symbol aus mehreren Chips besteht, ist es auch möglich, statt der Anzahl der Symbole oder Bits die Anzahl der Chips zu bestimmen bzw. zu zählen. Wenn jeweils die entsprechende Anzahl und somit auch die Größe $\Delta_k$ mit Hilfe eines Zählers bestimmt worden ist, lässt sich daraus indirekt bei bekannter Datenrate leicht die entsprechende Zeitdauer $\Delta t_k$ ableiten.

In einem zweiten Schritt wird der Stromverbrauch im Beobachtungs-Zeitraum $\Delta t$ derart berechnet, dass die im ersten Schritt bestimmten charakteristischen Größen $\Delta_k$ und Zustands-abhängige, typische Ströme $i_k$ für die im Zeitraum $\Delta t$ auftretenden Systemzustände berücksichtigt werden.

Die Zustands-abhängige Berechnung ermöglicht es, dass die den Zuständen zugeordneten Stromverbrauchskomponenten direkt für die Bestimmung des Stromverbrauches herangezogen werden können. Ergeben sich große Zustands-abhängige Unterschiede im Stromverbrauch, kann mit sehr einfachen Mitteln eine relativ genaue Bestimmung des Stromverbrauchs durchgeführt werden, indem lediglich die mit entsprechenden Zuständen verbundenen maßgeblichen Stromverbrauchskomponenten berücksichtigt werden. Damit bietet das erfindungsgemäße Verfahren den Vorteil, dass die Methode zur Bestimmung des Stromverbrauchs einfach und aufwandsminimal, aber dennoch hinreichend genau arbeitet.

Die Systemzustände können ferner einen Frequenzwechsel-Zustand, in welchem in der Mobilstation ein Frequenzwechsel der Trägerfrequenz durchführt wird, und/oder einen inaktiven Zustand, in welchem sich die Mobilstation weder im Empfangs/Sendezustand oder alternativ weder im Empfangszustand noch im Sendezustand und auch nicht im Frequenzwechsel-Zustand befindet, aber der Prozessor der Mobilstation weiterhin mit Takt und Spannung versorgt wird, und/oder einen Niederenergiemodus, in welchem der Prozessor mit reduziertem oder abgeschaltetem Takt- und/oder reduzierter oder abgeschalteter Spannung versorgt wird, umfassen.

Mit den wenigen oben vorgestellten Zuständen ist eine umfassende Zustands-orientierte Charakterisierung des Mobilfunkgerätes möglich. Damit lässt sich auf einfache Art und Weise - also durch wenige Rechen- und Speicheroperationen - der Stromverbrauch hinreichend genau bestimmen; lediglich eine geringe Anzahl Zustands-abhängiger, typischer Ströme $i_k$ muss dafür bekannt sein, d. h. müssen in einer Speichereinrichtung ablegt sein.

Bei Mobilfunksystemen, welche nach dem Frequenzsprungverfahren (frequency-hopping) arbeiten, kann die Zeitdauer, in der sich die Mobilstation in einem Frequenzwechsel-Zustand befindet, einen nicht unerheblichen Anteil an dem Beobachtungs-Zeitraum $\Delta t$ ausmachen. Damit verbunden ist ein nicht unerheblicher Anteil am Gesamtstromverbrauch. Insbesondere bei Systemen basierend auf einem schnellen Frequenzsprungverfahren (fast frequency-hopping), bei welchem pro Symboldauer mehrere Trägerfrequenzen durchlaufen werden, kann dieser Anteil relativ groß Anteil sein und sollte daher bei der Berechnung des Stromverbrauchs Berücksichtigung finden.

In einer vorteilhaften Ausführungsform wird der Empfangs/Sendezustand oder alternativ der Empfangszustand und/oder der Sendezustand in unterschiedliche Empfangs/Sendezustände bzw. Empfangszustände bzw. Sendezustände mit unterschiedlichen Datenraten untergliedert.

Die Berücksichtigung mehrerer Empfangs/Sendezustände oder alternativ mehrerer Empfangszustände oder Sendezustände mit unterschiedlichen Datenraten ist von Vorteil, da bei dieser Ausführungsform der erfindungsgemäßen Berechnung des Stromverbrauchs der Tatsache Rechnung getragen wird, dass in modernen Mobilfunksystemen die Datenrate an die jeweiligen Randbedingungen - teilweise sogar in adaptiver Form - anpassbar ist. Ist beispielsweise die Kommunikation bei einem gegebenen Signal-zu-Rauschverhältnis und einer bestimmten Datenrate nicht möglich, wird beispielsweise die Datenrate, insbesondere über eine Änderung der Modulationsart oder Verwendung einer anderen Codierung, reduziert.

Nach einer dazu vorteilhaften Ausführungsform wird vorausgesetzt, dass bei mehreren Empfangs/Sendezuständen oder alternativ bei mehreren Empfangszuständen und/oder Sendezuständen die unterschiedlichen Datenraten durch unterschiedliche Symbolraten hervorgerufen werden. In diesem Fall sind die Zustands-abhängigen, typischen Ströme $i_k$ für diese Empfangs/Sendezustände bzw. Empfangszustände bzw. Sendezustände proportional zu den Symbolraten dieser Zustände.

Dies bietet den Vorteil, dass im Allgemeinen die Berechnung des Stromverbrauchs in sehr einfacher Art und Weise durchgeführt werden kann, da durch die bekannten Proportionalitäten eine geringere Menge an Informationen hinsichtlich der typischen Ströme $i_k$ im Speicher abgelegt werden muss.

In analoger Weise wird in einer weiteren bevorzugten Ausführungsform jeweils der Wert der charakteristischen Größe $\Delta_k$ des Frequenzwechsel-Zustands durch Zählen der über den Zeitraum $\Delta t$ auftretenden Frequenzwechsel-Zustände bestimmt. Alternativ kann der Wert dieser Größe durch Messen der über den Zeitraum $\Delta t$ auftretenden Zeitdauer $\Delta t_k$, in welcher sich die Mobilstation in einem Frequenzwechsel-Zustand befindet, ermittelt werden.

Da im Allgemeinen die Trägerfrequenz über eine Phasenregelschleife (PLL: phase-locked loop) ausgewählt wird, lässt sich anhand der charakteristischen Größen der PLL, beispielsweise Bandbreite und Dämpfung, das Einschwingverhalten der PLL von einer Trägerfrequenz zur nächsten Trägerfrequenz ermitteln. Die resultierende Einschwingzeit kann werkseitig im Mobilfunkgerät abgelegt sein oder kann mit Hilfe einfacher analytischer Gleichungen im Betrieb bestimmt werden. Die Zeitdauer $\Delta t_k$ ergibt sich dann in einfacher Form aus der Einschwingzeit der PLL multipliziert mit der Anzahl der über den Zeitraum $\Delta t$ auftretenden Frequenzwechsel-Zustände.

In vorteilhafter Weise wird der Wert der charakteristischen Größe $\Delta_k$ für den Niederenergiezustand nach Bestimmung der Werte der charakteristischen Größen $\Delta_k$ für alle anderen im Zeitraum $\Delta t$ auftretenden Zustände bestimmt. Dabei wird die Differenz zwischen dem Zeitraum $\Delta t$ und den Zeitdauern $\Delta t_k$ aller anderen im Zeitraum $\Delta t$ auftretenden Systemzustände gebildet.

Dies bietet den Vorteil, dass der Wert der charakteristischen Größe $\Delta_k$ für den Niederenergiezustand - auch LPM (low power mode) genannt - ohne direkte Messung während des Niederenergiezustands ermittelt werden kann. Die erfindungsgemäße indirekte Bestimmung der charakteristischen Größe $\Delta_k$ für den Niederenergiezustand vermeidet so eine zu Strommesszwecken zusätzliche Leistungsaufnahme beim Betrieb im Niederenergiezustand. Darüber hinaus kann durch die indirekte Bestimmung auf einen weiteren Zähler, welcher dem Niederenergiezustand zugeordnet ist, verzichtet werden.

In einer weiteren vorteilhaften Ausführungsform wird das erfindungsgemäße Verfahren derart verfeinert, dass ein oder mehrere Zustands-abhängige Ströme $i_k$ von einem oder mehreren weiteren Parametern abhängig sind. Insbesondere können die Ströme $i_k$ in Relation zu den beiden Größen Versorgungsspannung oder Temperatur gesetzt werden. Darüber hinaus können durch eine Parametrisierung der Zustands-abhängigen Ströme $i_k$ auch Bauelementetoleranzen berücksichtigt werden.

Dies bietet den Vorteil, dass die Genauigkeit des Berechnungsverfahrens weiter erhöht werden kann. Der dafür notwendige Aufwand ist gering, da der tatsächliche Wert der Versorgungsspannung und der Wert der momentanen Chiptemperatur im Allgemeinen im Mobilfunkgerät zur Verfügung stehen oder leicht bestimmbar sind. Über die Einbeziehung von Bauelementetoleranzen können zusätzlich sogenannte Worst- oder Best-Case-Werte (Ober- oder Untergrenzen) für den Stromverbrauch bestimmt werden. Darüber hinaus lassen sich damit auch Chargen-spezifische oder sogar Mobilgerät-spezifische Einflüsse über die werkseitige Abspeicherung der entsprechenden Kenngrößen leicht berücksichtigen.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnungen näher erläutert; in diesen zeigen:

Fig. 1 eine schematische Darstellung einer Mobilstation eines digitalen Mobilfunksystems;

Fig. 2 eine Darstellung der Systemzustände und deren zeitliches Auftreten im Beobachtungszeitraum $\Delta t$;

Fig. 3 eine Darstellung einer Zähleinrichtung mit darin befindlichen Zählern $S_1$-$S_4$ sowie den entsprechenden Zählerständen $\Delta_1$-$\Delta_4$; und

Fig. 4 eine Darstellung eines Speichers mit 5 Speicherzellen $S_1$-$S_5$ mit darin abgelegten Zustands-abhängigen, typischen Strömen $i_1$-$i_5$.

Nachfolgende Betrachtungen orientieren sich an Mobilstationen in digitalen Mobilfunksystemen, insbesondere Bluetooth- oder DECT-Systeme; die Erfindung betrifft jedoch nicht nur Anwendungsfälle im Bereich der Mobilkommunikation, sondern ist auf alle Arten elektrisch betriebener mobiler Geräte anwendbar.

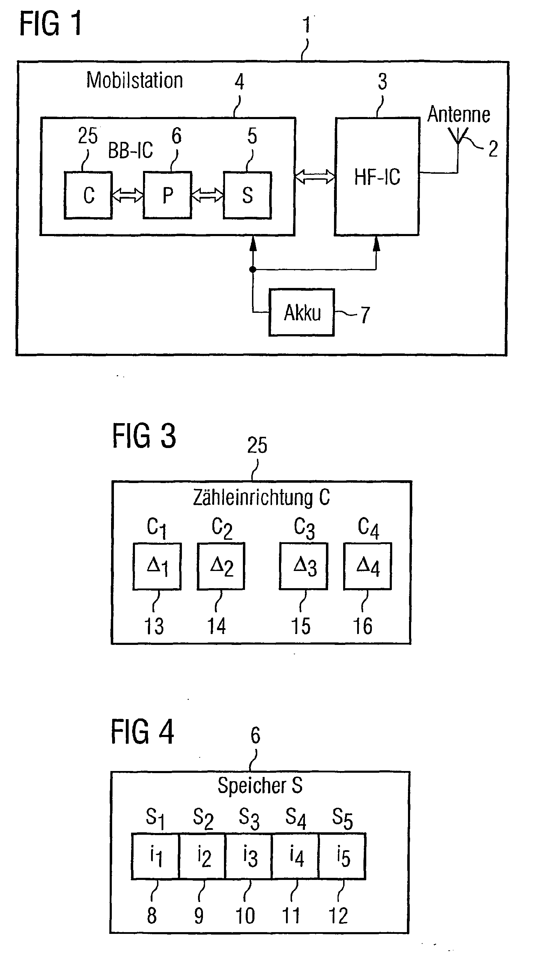

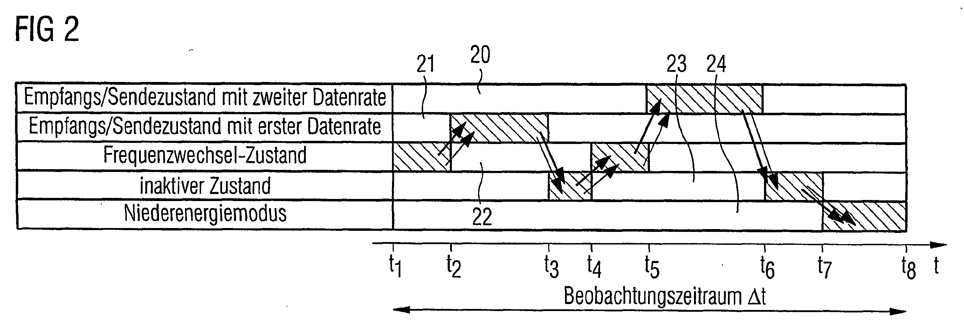

Fig. 1 zeigt den Aufbau einer Mobilstation 1, welche die erfindungsgemäße Messung des Stromverbrauchs durchführt.

Eine Antenne 2 ist mit einem monolithisch-integrierten Hochfrequenzbaustein 3 (HF-IC) bidirektional verbunden. Der HF-IC 3 weist eine bidirektionale Schnittstelle zu einem monolithisch-integrierten Basisbandbaustein 4 (BB-IC) auf. In dem BB-IC 4 sind ein Prozessor 5 mit einem Speicher 6, sowie der Prozessor 5 mit einer Zählereinrichtung 25 elektrisch verbunden. Ein Akku 7 ist mit beiden Bausteinen, dem BB-IC und dem HF-IC elektrisch verbunden.

Dabei werden die in der Antenne 2 empfangenen oder abgestrahlten Signale im HF-IC 3 demoduliert bzw. moduliert. Die Weiterverarbeitung der empfangenen Signale bzw. die Vorverbeitung der zu sendenden Signale wird dabei in dem BB-IC 4 durchgeführt. Dieser umfasst einen Prozessor 5, einen Speicher 6 und die Zähleinrichtung 25, welche bei der erfindungsgemäßen Berechnung des Stromverbrauchs beteiligt sind. Beide Bausteine 3, 4 werden von dem Akku 7 mit Betriebsspannung versorgt. Daneben führt die Akku auch eine Betriebsspannungsversorgung anderer Bauteile der Mobilstation 1 durch, welche hier nicht dargestellt sind.

Es wird davon ausgegangen, dass sich die Mobilstation während eines Zeitraums $\Delta t$ in einem oder mehreren der folgenden Zustände befinden kann:

a) in mehreren Empfangs/Sendezuständen (jeder Zustand jeweils als RX-TX-Phase bezeichnet), in welchen die Mobilstation im Empfangsbetrieb oder im Sendebetrieb arbeitet, wobei sich die Empfangs/Sendezustände jeweils dadurch unterscheiden, dass die Informationsübertragung jeweils mit einer unterschiedlichen Datenrate durchgeführt wird, oder

b) in einem Frequenzwechsel-Zustand (auch PLL-settle-Phase genannt), in welchem in der Mobilstation ein Frequenzwechsel der Trägerfrequenz durchführt wird, oder

c) in einem inaktiven Zustand, in welchem sich die Mobilstation weder in einem Empfangs/Sendezustand noch im Frequenzwechsel-Zustand befindet, aber der Prozessor der Mobilstation weiterhin mit Takt und Spannung versorgt wird, oder

d) in einem Niederenergiemodus, in welchem der Prozessor mit reduziertem oder abgeschaltetem Takt- und/oder reduzierter oder abgeschalteter Spannung versorgt wird.

Im folgenden wird zur Vereinfachung angenommen, dass lediglich zwei Empfangs/Sendezustände vorliegen können, die eine unterschiedliche Datenrate aufweisen.

Das zeitliche Auftreten der möglichen 5 Systemzustände 20-24 im Beobachtungszeitraum $\Delta t$ ist in Fig. 2 für einen beispielhaften Fall dargestellt. Von dem Zeitpunkt $t_1$ bis zum Zeitpunkt $t_2$ befindet sich die Mobilstation im Frequenzwechsel-Zustand 22. Vom Zeitpunkt $t_2$ bis zum Zeitpunkt $t_3$ ist die Mobilstation in einem ersten Empfangs/Sendezustand 21 mit einer ersten Datenrate. Im weiteren Zeitverlauf werden sukzessive weitere Zustände durchlaufen.

Zur Bestimmung des Stromverbrauchs in dem Beobachtungszeitraum $\Delta t$ werden folgende Operationen durchgeführt:

1. Zählen der Anzahl $\Delta_1$ der über den Zeitraum $\Delta t$ auftretenden Frequenzwechsel-Zustände 22 über einen in der Zähleinrichtung 25 befindlichen Zähler $C_1$, und

2. Messen mit Hilfe eines in der Zähleinrichtung 25 befindlichen Zählers $C_2$ (beispielsweise über das Zählen von Systemzyklen) der über den Zeitraum $\Delta t$ auftretenden Zeitdauer $\Delta t_2$, in welcher sich die Mobilstation in einem inaktiven Systemzustand 23 befindet, wobei $\Delta_2 = \Delta t_2$ gilt, und

3. Zählen der Anzahl $\Delta_3$ der gesendeten und empfangenen Symbole oder Bits über einen in der Zähleinrichtung 25 befindlichen Zähler $C_3$ hinsichtlich des Empfangs/Sendezustands mit der ersten Datenrate 21, und

4. Zählen der Anzahl $\Delta_4$ der gesendeten und empfangenen Symbole oder Bits über einen in der Zähleinrichtung 25 befindlichen Zähler $C_4$ hinsichtlich des Empfangs/Sendezustands mit der zweiten Datenrate 20.

In Fig. 3 ist die Zähleinrichtung 25 mit den darin befindlichen in Hardware realisierten Zählern $C_1$-$C_4$ 13-16 dargestellt, wobei diese entsprechende Zählerstände $\Delta_1$-$\Delta_4$ aufweisen. Sofern die Zähler $C_1$-$C_4$ in Software ausgeführt sind (d.h. die Zählungen von dem Prozessor 5 durchgeführt werden), entfällt die Zähleinrichtung 25.

Aus den Ergebnissen der Operationen aus 1., 3. und 4. werden im Prozessor 6 nach dem Zeitraum $\Delta t$ aus den in den Zählern 13, 15, 16 der Zähleinrichtung 25 vorliegenden Zählerständen $\Delta_1$, $\Delta_3$, $\Delta_4$ die zuzuordnenden Zeitdauern $\Delta t_1$, $\Delta t_3$ bzw. $\Delta t_4$ bestimmt.

Unter der Voraussetzung, dass $\Delta_3$ die Anzahl der Symbole darstellt, ergibt sich die Zeitdauer $\Delta t_3$, in der sich die Mobilstation im Empfangs/Sendezustand mit der ersten Datenrate 21 befand, zu:

$$\Delta t_3 = \Delta_3 \times t_{symbol,1} \qquad (1a),$$

wobei $t_{symbol,1}$ die Symboldauer des Zustands mit einer ersten Datenrate 21 darstellt.

Gilt alternativ, dass $\Delta_3$ die Anzahl der Bits darstellt, ergibt sich die Zeitdauer $\Delta t_3$, in der sich die Mobilstation im Empfangs/Sendezustand mit der ersten Datenrate 21 befand, zu:

$$\Delta t_3 = (\Delta_3 / N_1) \times t_{symbol,1} \qquad (1b),$$

wobei $t_{symbol,1}$ die Symboldauer des Zustands mit einer ersten Datenrate 21 darstellt und jedes Symbol $N_1$ Bits beinhaltet.

Für die Bestimmung der Zeitdauer $\Delta t_4$ des Empfangs/Sendezustand mit der zweiten Datenrate 20 gelten die gleichen Aussagen hinsichtlich des Zählens von Symbolen oder Bits. Gibt $\Delta_4$ die Anzahl der Bits an, bestimmt sich die entsprechende Zeitdauer für den Empfangs/Sendezustand mit der zweiten Datenrate 22 zu:

$$\Delta t_4 = (\Delta_4 / N_2) \times t_{symbol,2} \qquad\qquad (2),$$

wobei $t_{symbol,2}$ die Symboldauer des Zustands mit der zweiten Datenrate 20 darstellt und jedes Symbol dann $N_2$ Bits beinhaltet.

Zwei Sonderfälle können dabei unterschieden werden:

1. Im Falle unterschiedlicher Datenraten hervorgerufen durch unterschiedliche Modulationsarten (beispielsweise DQPSK-Modulation und D8PSK-Modulation) gilt:

$$t_{symbol,1} = t_{symbol,2} \text{ und } N_1 \neq N_2 \qquad\qquad (3).$$

2. Im Falle unterschiedlicher Datenraten hervorgerufen durch unterschiedliche Symbolraten gilt:

$$t_{symbol,1} \neq t_{symbol,2} \text{ und } N_1 = N_2 \qquad\qquad (4).$$

Die Zeitdauer $\Delta t_1$, in der sich die Mobilstation im Frequenzwechsel-Zustand 22 befand, welcher dadurch charakterisiert ist, dass die PLL noch nicht synchron zu einer gewählten Trägerfrequenz arbeitete, lässt sich folgendermaßen bestimmen:

$$\Delta t_1 = \Delta_1 \times t_{settle} \qquad\qquad (5),$$

wobei $t_{settle}$ die Einschwingdauer der PLL bei einem Frequenzwechsel angibt. Die Einschwingdauer $t_{settle}$ wird anhand der charakteristischen Größen der PLL, Bandbreite und Dämpfung, ermittelt und ist bei der Anwendung des Verfahrens bereits im Speicher abgelegt.

Damit bestimmt sich die charakteristische Größe $\Delta_5$ oder Zeitdauer $\Delta t_5$ des Niederenergiemodus 24, in welcher der Prozessor mit reduziertem oder abgeschaltetem Takt- und/oder reduzierter oder abgeschalteter Spannung versorgt wird, indirekt aus $\Delta t_1$, $\Delta t_2$, $\Delta t_3$ und $\Delta t_4$ über:

$$\Delta_5 = \Delta t_5 = \Delta t - (\Delta t_1 + \Delta t_2 + \Delta t_3 + \Delta t_4) \qquad\qquad (6).$$

Die in dem Beobachtungs-Zeitraum $\Delta t$ verbrauchte Ladung $\Delta Q$ wird damit folgendermaßen in dem Prozessor 5 mit Zugriff auf die im Speicher 6 ablegten Größen $i_k$ berechnet:

$$\Delta Q = \Delta t_1 \times i_1 + \Delta t_2 \times i_2 + \Delta t_3 \times i_3 + \Delta t_4 \times i_4 + \Delta t_5 \times i_5 \qquad (7),$$

wobei die Größen $i_k$ die Zustands-abhängigen, typischen Ströme der jeweiligen Zustände angeben.

In Fig. 4 ist die Belegung des Speichers 6 mit den Zustands-abhängigen, typischen Ströme $i_k$ dargestellt. Hierbei sind in den Speicherzellen $S_1$-$S_5$ 8-12 die entsprechenden Zustands-abhängigen, typischen Ströme $i_1$-$i_5$ abgelegt, welche vom Prozessor 6 bei der Berechnung des Stromverbrauchs verwendet werden.

Die Rechnung nach Gleichung (7) kann vereinfacht werden, wenn die typischen Ströme $i_3$ und $i_4$ bei unterschiedlichen Symbolraten (Fall 2.) proportional zueinander sind und die Proportionalität in der Berechnung in Schritt b) durch einen Proportionalitätsfaktor P mit $i_4 = P \times i_3$ ausgenutzt wird.

Darüber hinaus kann zusätzlich zu der Berechnung in Gleichung (7) die mittlere Stromaufnahme $I_{mean}$ in dem Zeitraum $\Delta t$ berechnet werden. Diese bestimmt sich zu:

$$I_{mean} = \Delta Q \: / \: \Delta t \qquad\qquad (8).$$

Es wird darauf hingewiesen, dass bei der Verwendung von normierten Größen $\Delta t_k/\Delta t$ anstelle $\Delta t_k$ oder $i_k/\Delta t$ anstelle $i_k$ aus Gleichung (7) auch direkt $I_{mean}$ ermittelt werden kann, ohne dass zunächst die Ladungsmenge $\Delta Q$ bestimmt wird.

**Patentansprüche**

1. Verfahren zum Berechnen einer verbrauchten Ladung Q bezogen auf einen Zeitraum $\Delta t$ in einer Mobilstation (1) eines Mobilfunksystems mit netz-unabhängiger Stromversorgung, welche sich in dem Zeitraum $\Delta t$ in verschiedenen Systemzuständen (20-24) befinden kann, wobei die Systemzustände

   - einen Empfangs/Sendezustand (20, 21), in welchem die Mobilstation im Empfangsbetrieb oder im Sendebetrieb arbeitet, oder alternativ
   - einen Empfangszustand, in welchem die Mobilstation im Empfangsbetrieb arbeitet, und einen Sendezustand, in welchem die Mobilstation im Sendebetrieb arbeitet,

   umfassen,
   mit den Schritten:

   a) Bestimmen jeweils eines Wertes einer für die Zeitdauer $\Delta t_k$ eines Systemzustands $s_k$ (20-24) charakteristischen Größe $\Delta_k$ für im Zeitraum $\Delta t$ auftretende Systemzustände (20-24), wobei das Bestimmen des Wertes der charakteristischen Größe $\Delta_k$ eines Empfangs/Sendezustands (20, 21) oder alternativ eines Empfangszustands oder Sendezustands durch Bestimmen der Anzahl, insbesondere durch Zählen (15, 16), der über den Zeitraum $\Delta t$ empfangenen und gesendeten bzw. empfangenen bzw. gesendeten Symbole, Bits oder Chips in dem jeweiligen Zustand erfolgt; und
   b) Berechnen der verbrauchten Ladung Q bezogen auf den Zeitraum $\Delta t$ unter Berücksichtigung

   - der im Schritt a) bestimmten charakteristischen Größen $\Delta_k$, und
   - von Zustands-abhängigen, typischen Strömen $i_k$ für die im Zeitraum $\Delta t$ auftretenden Systemzustände (20-24).

2. Verfahren nach Anspruch 1,
   **dadurch gekennzeichnet,**
   **dass** die Systemzustände, in denen sich die Mobilstation befinden kann, ferner umfassen:

   - einen Frequenzwechsel-Zustand (22), in welchem in der Mobilstation ein Frequenzwechsel der Trägerfrequenz durchgeführt wird, und/oder
   - einen inaktiven Zustand (23), in welchem sich die Mobilstation weder im Empfangs/Sendezustand oder alternativ weder im Empfangszustand noch im Sendezustand und auch nicht im Frequenzwechsel-Zustand befindet, aber der Prozessor (4, 6) der Mobilstation weiterhin mit Takt und Spannung versorgt wird, und/oder
   - einen Niederenergiemodus (24), in welchem der Prozessor (4, 6) mit reduziertem oder abgeschaltetem Takt- und/oder reduzierter oder abgeschalteter Spannung versorgt wird.

3. Verfahren nach Anspruch 2,
   **dadurch gekennzeichnet,**
   **dass** der Empfangs/Sendezustand (20, 21) oder alternativ der Empfangszustand und/oder der Sendezustand in unterschiedliche Empfangs/Sendezustände bzw. Empfangszustände bzw. Sendezustände mit unterschiedlichen Datenraten untergliedert werden.

4. Verfahren nach Anspruch 3,
   **dadurch gekennzeichnet,**
   **dass** bei mehreren Empfangs/Sendezuständen (20, 21) oder alternativ bei mehreren Empfangszuständen und/oder Sendezuständen die unterschiedlichen Datenraten durch unterschiedliche Symbolraten hervorgerufen werden und die Zustands-abhängigen, typischen Ströme $i_k$ für diese Empfangs/Sendezustände (20, 21) bzw. Empfangszustände bzw. Sendezustände proportional zu den Symbolraten dieser Zustände sind.

5. Verfahren nach einem der Ansprüche 2 bis 4,
**gekennzeichnet durch**
den Schritt:

- Bestimmen des Wertes der charakteristischen Größe $\Delta_k$ des Frequenzwechsel-Zustands (22) in Schritt a) **durch** Zählen (13) der über den Zeitraum $\Delta t$ auftretenden Frequenzwechsel-Zustände oder **durch** Messen der über den Zeitraum $\Delta t$ auftretenden Zeitdauer $\Delta t_k$, in welcher sich die Mobilstation in einem Frequenzwechsel-Zustand befindet.

6. Verfahren nach einem der Ansprüche 2 bis 5,
**gekennzeichnet durch**
den Schritt:

- Bestimmen der charakteristischen Größe $\Delta_k$ des inaktiven Zustands $s_k$ (23) in Schritt a) **durch** Messen, insbesondere mit Hilfe eines Zählers (14), der über den Zeitraum $\Delta t$ auftretenden Zeitdauer $\Delta t_k$, in welcher sich die Mobilstation in einem inaktiven Systemzustand (23) befindet.

7. Verfahren nach einem der Ansprüche 2 bis 6,
**gekennzeichnet durch**
den Schritt:

- Bestimmen des Wertes der charakteristischen Größe $\Delta_k$ für den Niederenergiezustand (24) nach Bestimmung der Werte der charakteristischen Größen $\Delta_k$ für alle anderen im Zeitraum $\Delta t$ auftretenden Zustände (20-23) in Schritt a) **durch** Bilden der Differenz zwischen dem Zeitraum $\Delta t$ und den Zeitdauern $\Delta t_k$ aller anderen im Zeitraum $\Delta t$ auftretenden Systemzustände (20-23).

8. Verfahren nach einem der vorhergehenden Ansprüche,
**dadurch gekennzeichnet,**
**dass** zur Berechnung der verbrauchten Ladung Q bezogen auf den Zeitraum $\Delta t$ in Schritt b) folgende Rechenschritte durchgeführt werden:

- Multiplizieren der jeweiligen Zustands-abhängigen Zeitdauer $\Delta t_k$ mit dem zugeordneten Zustands-abhängigen typischen Strom $i_k$,
- Summieren der sich aus den Multiplikationen ergebenden Produkte.

9. Verfahren nach einem der vorhergehenden Ansprüche,
**dadurch gekennzeichnet,**
**dass** ein oder mehrere der Zustands-abhängigen Ströme $i_k$ von der Versorgungsspannung abhängig sind.

10. Verfahren nach einem der vorhergehenden Ansprüche,
**dadurch gekennzeichnet,**
**dass** ein oder mehrere der Zustands-abhängigen Ströme $i_k$ von der Temperatur abhängig sind.

11. Verfahren nach einem der vorhergehenden Ansprüche,
**dadurch gekennzeichnet,**
**dass** ein oder mehrere der Zustands-abhängigen Ströme $i_k$ von Bauelementetoleranzen abhängig sind.

12. Verfahren nach einem der vorhergehenden Ansprüche,
**dadurch gekennzeichnet,**
**dass** das Verfahren für die Vorausberechnung der Restbetriebsdauer eingesetzt wird.

13. Verfahren nach einem der vorhergehenden Ansprüche,
**dadurch gekennzeichnet,**
**dass** das Verfahren in einer Bluetooth-, DECT- oder WLAN-Mobilstation (1) eingesetzt wird.

14. Schaltungsanordnung zum Berechnen einer verbrauchten Ladung Q bezogen auf einen Zeitraum $\Delta t$ in einer Mo-

bilstation

(1) eines Mobilfunksystems mit netzunabhängiger Stromversorgung, welche sich in verschiedenen Systemzuständen (20-24) befinden kann, wobei die Systemzustände

- einen Empfangs/Sendezustand (20, 21), in welchem die Mobilstation im Empfangsbetrieb oder im Sendebetrieb arbeitet, oder alternativ
- einen Empfangszustand, in welchem die Mobilstation im Empfangsbetrieb arbeitet, und einen Sendezustand, in welchem die Mobilstation im Sendebetrieb arbeitet,

umfassen, mit:

- einem oder mehreren Bestimmungsmitteln (13-16) zum Bestimmen jeweils eines Wertes einer für die Zeitdauer $\Delta t_k$ eines Systemzustands $s_k$ charakteristischen Größe $\Delta_k$, wobei zum Bestimmen des Wertes die Bestimmungsmittel ausgelegt sind, die über den Zeitraum $\Delta t$ empfangenen und gesendeten bzw. empfangenen bzw. gesendaten Symbole, Bits oder Chips in dem jeweiligen Zustand zu zählen, und
- einem Berechnungsmittel (6) zum Berechnen der verbrauchten Ladung Q bezogen auf den Zeitraum $\Delta t$ in Abhängigkeit

- der in den Bestimmungsmitteln bestimmten Werten der charakteristischen Größen $\Delta_k$, und
- Zustands-abhängiger, typischer Ströme $i_k$ für die im Zeitraum $\Delta t$ auftretenden Systemzustände (20-24).

**15.** Schaltungsanordnung nach Anspruch 14,
**dadurch gekennzeichnet,**
**dass** ein oder mehrere Bestimmungsmittel als Zähler (13-16), insbesondere als Hardware- oder Software-Zähler, ausgeführt sind.

**16.** Schaltungsanordnung nach einem der Ansprüche 14 oder 15,
**dadurch gekennzeichnet,**
**dass** ein Bestimmungsmittel ausgelegt ist, den Wert der charakteristischen Größe $\Delta_k$ eines Niederenergiemodus $s_k$ (24) als Differenz zwischen

- dem Zeitraum $\Delta t$, und
- den Zeitdauern $\Delta t_k$ aller anderen im Zeitraum $\Delta t$ auftretenden Systemzustände (20-23)

zu berechnen,
wobei im Niederenergiemodus (24) der Prozessor (6, 4) mit reduziertem oder abgeschaltetem Takt- und/oder reduzierter oder abgeschalteter Spannung versorgt wird.

**17.** Schaltungsanordnung nach einem der Ansprüche 14 bis 16,
**dadurch gekennzeichnet,**
**dass** die Schaltungsanordnung in einer Bluetooth-, DECT- oder WLAN-Mobilstation (1) eingesetzt wird.

**Claims**

**1.** Method for calculation of a charge Q consumed in a time period $\Delta t$ in a mobile station (1) in a mobile radio system with a power supply which is independent of the mains and may be in different system states (20-24) in the time period $\Delta t$, with the system states comprising

- a receiving/transmitting state (20, 21) in which the mobile station operates in the receive mode or in the transmit mode, or alternatively
- a receiving state, in which the mobile station operates in the receive mode, and a transmitting state in which the mobile station operates in the transmit mode,

having the following steps:

a) a value of a variable $\Delta_k$, which is characteristic of the time period $\Delta t_k$ of a system state $s_k$ (20-24) is in each case determined for system states (20-24) which occur in the time period $\Delta t$, with the value of the characteristic variable $\Delta_k$ of a receiving/transmitting state (20, 21) or alternatively of a receiving state or transmitting state being determined by determining the number, in particular by counting (15, 16), of the symbols, bits or chips which have been received and transmitted over the time period $\Delta t$ in the respective state; and

    b) the charge Q consumed in the time period $\Delta t$ is calculated taking into consideration

- the characteristic variables $\Delta_k$ determined in step (a), and
- state-dependent typical currents $I_k$ for the system states (20-24) which occur in the time period $\Delta t$.

2. Method according to Claim 1,
**characterized**
**in that** the system states in which the mobile station may be furthermore comprise,

- a frequency-changing state (22) in which the carrier frequency is changed in the mobile station, and/or
- an inactive state (23), in which the mobile station is neither in the receiving/transmitting state or alternatively is neither in the receiving state nor in the transmitting state, and is also not in the frequency-changing state, but the processor (4, 6) of the mobile station is still supplied with clock and voltage, and/or
- a low-energy mode (24), in which the processor (4, 6) is supplied with reduced or switched-off clock, and/or a reduced or switched-off voltage.

3. Method according to Claim 2, **characterized in that** the receiving/transmitting state (20, 21) or alternatively the receiving state and/or the transmitting state are subdivided into different receiving/transmitting states or receiving states or transmitting states, respectively, with different data rates.

4. Method according to Claim 3, **characterized in that**, in the case of a number of receiving/transmitting states (20, 21) or alternatively in the case of a number of receiving states and/or transmitting states, the different data rates are caused by different symbol rates, and the state-dependent typical currents $i_k$ for these receiving/transmitting states (20, 21) or receiving states or transmitting states, respectively, are proportional to the symbol rates of these states.

5. Method according to one of Claims 2 to 4, **characterized by** the following step:

- the value of the characteristic variable $\Delta_k$ of the frequency-changing state (22) is determined in step a) by counting (13) the frequency-changing states occurring in the time period $\Delta t$ or by measuring the time period $\Delta t_k$, in which the mobile station is in a frequency-changing state, occurring in the period $\Delta t$.

6. Method according to one of Claims 2 to 5, **characterized by** the following step:

- the characteristic variable $\Delta_k$ of the inactive state $s_k$ (23) is determined in step a) by measuring, particularly with the aid of a counter (14), the time period $\Delta t_k$, in which the mobile station is in an inactive system state (23), occurring over the time period $\Delta t$.

7. Method according to one of Claims 2 to 6, **characterized by** the following step:

- the value of the characteristic variable $\Delta_k$ for the low-energy state (24) is determined after determining the values of the characteristic variables $\Delta_k$ for all the other states (20-23) occurring in the time period $\Delta t$ in step a) by forming the difference between the time period $\Delta t$ and the time periods $\Delta t_k$ of all other system states (20-23) occurring in the time period $\Delta t$.

8. Method according to one of the preceding claims, **characterized in that**, the following computing steps are carried out in order to calculate the charge Q consumed in the time period $\Delta t$ in step b):

- the respective state-dependent time period $\Delta t_k$ is multiplied by the associated state-dependent typical current $i_k$,
- the products resulting from the multiplications are added.

9. Method according to one of the preceding claims, **characterized in that** one or more of the state-dependent currents $i_k$ is or are dependent on the supply voltage.

**10.** Method according to one of the preceding claims, **characterized in that** one or more of the state-dependent currents $i_k$ is or are dependent on the temperature.

**11.** Method according to one of the preceding claims, **characterized in that** one or more of the state-dependent currents $i_k$ is or are dependent on component tolerances.

**12.** Method according to one of the preceding claims, **characterized in that** the method is used for precalculating the remaining operating time.

**13.** Method according to one of the preceding claims, **characterized in that** the method is used in a Bluetooth, DECT or WLAN mobile station (1).

**14.** Circuit arrangement for calculation of a charge Q consumed in a time period $\Delta t$ in a mobile station (1) in a mobile radio system with a power supply which is independent of the mains and may be in different system states (20-24), with the system states comprising:

- a receiving/transmitting state (20, 21) in which the mobile station operates in the receive mode or in the transmit mode, or alternatively
- a receiving state, in which the mobile station operates in the receive mode, and a transmitting state in which the mobile station operates in the transmit mode,

having:

- one or more determination means (13-16) for determining in each case one value of a variable $\Delta_k$ which is characteristic of the time period $\Delta t_k$ of a system state $s_k$, with the determination means for determination of the value being designed to count the symbols, bits or chips which have been received and transmitted over the time period $\Delta t$ in the respective state, and
- a calculation means (6) for calculation of the charge Q consumed in the time period $\Delta t$ as a function

- of the values of the characteristic variables $\Delta_k$ determined in the determination means, and
- of state-dependant typical currents $i_k$ for the system states (20-24) occurring in the time period $\Delta t$.

**15.** Circuit arrangement according to Claim 14, **characterized in that** one or more determination means are in the form of counters (13-16), particularly hardware or software counters.

**16.** Circuit arrangement according to one of Claims 14 or 15, **characterized in that** a determination means is designed to calculate the value of the characteristic variable $\Delta_k$ or of a low-energy mode $s_k$ (24) as the difference between

- the time period $\Delta t$, and
- the time periods $\Delta t_k$ of all other system states (20-23) occurring in the time period $\Delta t$,

with the processor (6, 4) being supplied with a reduced or switched-off clock and/or a reduced or switched-off voltage in the low-energy mode (24).

**17.** Circuit arrangement according to one of Claims 14 to 16, **characterized in that** the circuit arrangement is used in a Bluetooth, DECT or WLAN mobile station (1).

**Revendications**

**1.** Procédé de calcul d'une charge consommée Q par rapport à un intervalle de temps $\Delta t$ dans une station mobile (1) d'un système de radiocommunication mobile, laquelle station mobile a une alimentation en courant indépendante du réseau et peut se trouver pendant l'intervalle de temps $\Delta t$ dans différents états de système (20 à 24), les états de système comprenant :

- un état de réception / émission (20, 21) dans lequel la station mobile travaille en mode de réception ou en mode d'émission,
ou selon une variante

- un état de réception dans lequel la station mobile travaille en mode de réception et un état d'émission dans lequel la station mobile travaille en mode d'émission,

avec les étapes de :

a) détermination à chaque fois d'une valeur d'une grandeur $\Delta_k$ caractéristique de la durée $\Delta t_k$ d'un état de système $s_k$ (20 à 24) pour des états de système (20 à 24) apparaissant dans l'intervalle de temps $\Delta t$, la détermination de la valeur de la grandeur caractéristique $\Delta k$ d'un état de réception / émission (20, 21) ou selon une variante d'un état de réception ou d'un état d'émission s'effectuant au moyen de la détermination du nombre, notamment par comptage (15, 16), des symboles, bits ou éléments reçus et émis ou reçus ou émis pendant l'intervalle de temps $\Delta t$ dans l'état respectif ; et
b) calcul de la charge consommée Q par rapport à l'intervalle de temps $\Delta t$ en tenant compte

- des grandeurs caractéristiques $\Delta_k$ déterminées dans l'étape a), et
- de courants $i_k$ typiques, dépendants de l'état, pour les états de système (20 à 24) apparaissant pendant l'intervalle de temps $\Delta t$.

2. Procédé selon la revendication 1,
**caractérisé par le fait que**
les états de système dans lesquels la station mobile peut se trouver comprennent en plus :

- un état de changement de fréquence (22) dans lequel un changement de la fréquence porteuse est effectué dans la station mobile, et/ou
- un état inactif (23) dans lequel la station mobile ne se trouve ni dans l'état de réception / émission ou selon une variante ni dans l'état de réception ni dans l'état d'émission et pas non plus dans l'état de changement de fréquence, le processeur (4, 6) de la station mobile continuant toutefois à être alimenté en horloge et tension, et/ou
- un mode d'économie d'énergie (24) dans lequel le processeur (4, 6) est alimenté avec une horloge réduite et/ou coupée et/ou avec une tension réduite et/ou coupée.

3. Procédé selon la revendication 2,
**caractérisé par le fait que**
l'état de réception / émission (20, 21) ou selon une variante l'état de réception et/ou l'état d'émission sont décomposés en états de réception / émission ou états de réception ou états d'émission avec différents débits de données.

4. Procédé selon la revendication 3,
**caractérisé par le fait que**,
en présence de plusieurs états de réception / émission (20, 21) ou selon une variante en présence de plusieurs états de réception et/ou états d'émission, les différents débits de données sont dus à des taux de symboles différents et les courants $i_k$ typiques, dépendants des états, pour ces états de réception / émission (20, 21) ou états de réception ou états d'émission sont proportionnels aux taux de symboles de ces états.

5. Procédé selon l'une des revendications 2 à 4,
**caractérisé par** l'étape de :

- détermination de la valeur de la grandeur caractéristique $\Delta_k$ de l'état de changement de fréquence (22) dans l'étape a) par comptage (13) des états de changement de fréquence apparaissant pendant l'intervalle de temps $\Delta t$ ou par mesure de la durée $\Delta t_k$, apparaissant pendant l'intervalle de temps $\Delta t$, pendant laquelle la station mobile se trouve dans un état de.changement de fréquence.

6. Procédé selon l'une des revendications 2 à 5,
**caractérisé par** l'étape de :

- détermination de la grandeur caractéristique $\Delta_k$ de l'état inactif $s_k$ (23) dans l'étape a) par mesure, notamment à l'aide d'un compteur (14), de la durée $\Delta t_k$, apparaissant pendant l'intervalle de temps $\Delta t$, pendant laquelle la station mobile se trouve dans un état de système inactif (23).

7. Procédé selon l'une des revendications 2 à 6,
**caractérisé par** l'étape de :

- détermination de la grandeur caractéristique $\Delta_k$ de l'état d'économie d'énergie (24) après détermination des valeurs des grandeurs caractéristiques $\Delta_k$ de tous les autres états (20 à 23) apparaissant pendant l'intervalle de temps $\Delta t$ dans l'étape a) par formation de la différence entre l'intervalle de temps $\Delta t$ et les durées $\Delta t_k$ de tous les autres états de système (20 à 23) apparaissant pendant l'intervalle de temps $\Delta t$.

8. Procédé selon l'une des revendications précédentes,
   **caractérisé par le fait que**,
   pour le calcul de la charge consommée Q par rapport à l'intervalle de temps $\Delta t$, on réalise dans l'étape b) les étapes de calcul suivantes :

   - multiplication des durées $\Delta t_k$ respectives, dépendantes des états, par le courant typique $i_k$ associé, dépendant des états,
   - addition des produits résultant des multiplications.

9. Procédé selon l'une des revendications précédentes,
   **caractérisé par le fait que**
   un ou plusieurs courants $i_k$ dépendants des états sont dépendants de la tension d'alimentation.

10. Procédé selon l'une des revendications précédentes,
    **caractérisé par le fait que**
    un ou plusieurs courants $i_k$ dépendants des états sont dépendants de la température.

11. Procédé selon l'une des revendications précédentes,
    **caractérisé par le fait que**
    un ou plusieurs courants $i_k$ dépendants des états sont dépendants des tolérances des composants.

12. Procédé selon l'une des revendications précédentes,
    **caractérisé par le fait que**
    le procédé est utilisé pour le calcul préalable de la durée de fonctionnement restante.

13. Procédé selon l'une des revendications précédentes,
    **caractérisé par le fait que**
    le procédé est utilisé dans une station mobile (1) Bluetooth, DECT ou WLAN.

14. Circuit de calcul d'une charge consommée Q par rapport à un intervalle de temps $\Delta t$ dans une station mobile (1) d'un système de radiocommunication mobile, laquelle station mobile a une alimentation en courant indépendante du réseau et peut se trouver dans différents états de système (20 à 24), les états de système comprenant

    - un état de réception / émission (20, 21) dans lequel la station mobile travaille en mode de réception ou en mode d'émission,
    ou selon une variante
    - un état de réception dans lequel la station mobile travaille en mode de réception et un état d'émission dans lequel la station mobile travaille en mode d'émission,

    avec :

    - un ou plusieurs moyens de détermination (13 à 16) pour déterminer à chaque fois une valeur d'une grandeur $\Delta_k$ caractéristique de la durée $\Delta t_k$ d'un état de système $s_k$, les moyens de détermination pour la détermination de la valeur étant conçus pour compter des symboles, bits ou éléments reçus et émis ou reçus ou émis pendant l'intervalle de temps $\Delta t$ dans l'état respectif, et
    - un moyen de calcul (6) pour calculer la charge consommée Q par rapport à l'intervalle de temps $\Delta t$ en fonction

      - des valeurs, déterminées dans les moyens de détermination, des grandeurs caractéristiques $\Delta_k$, et
      - de courants $i_k$ typiques, dépendants de l'état, pour les états de système (20 à 24) apparaissant pendant l'intervalle de temps $\Delta t$.

15. Circuit selon la revendication 14,
    **caractérisé par le fait que**

un ou plusieurs moyens de détermination sont réalisés comme des compteurs (13 à 16), notamment comme des compteurs matériels ou logiciels.

16. Circuit selon l'une des revendications 14 ou 15,
    **caractérisé par le fait que**
    un moyen de détermination est conçu pour calculer la valeur de la grandeur caractéristique $\Delta k$ d'un mode d'économie d'énergie $s_k$ (24) en tant que différence entre

    - l'intervalle de temps $\Delta t$, et
    - les durées $\Delta t_k$ de tous les autres états de système (20 à 23) apparaissant pendant l'intervalle de temps $\Delta t$,

    le processeur (6, 4) étant alimenté pendant le mode d'économie d'énergie (24) avec une horloge réduite et/ou coupée et/ou avec une tension réduite et/ou coupée.

17. Circuit selon l'une des revendications 14 à 16,
    **caractérisé par le fait que**
    le circuit est utilisé dans une station mobile (1) Bluetooth, DECT ou WLAN.

## FIG 1

Mobilstation 4 3

Antenne

25 BB-IC 6 5

| C | ⇄ | P | ⇄ | S | ⇄ | HF-IC |

Akku ~7

1

2

## FIG 3

25

Zähleinrichtung C

| $C_1$ | $C_2$ | $C_3$ | $C_4$ |
|-------|-------|-------|-------|
| $\Delta_1$ | $\Delta_2$ | $\Delta_3$ | $\Delta_4$ |
| 13 | 14 | 15 | 16 |

## FIG 4

6

Speicher S

| $S_1$ | $S_2$ | $S_3$ | $S_4$ | $S_5$ |
|-------|-------|-------|-------|-------|
| $i_1$ | $i_2$ | $i_3$ | $i_4$ | $i_5$ |
| 8 | 9 | 10 | 11 | 12 |

# FIG 2

| | 21 | 20 | | 23 24 |
|---|---|---|---|---|

| | | |
|---|---|---|
| Empfangs/Sendezustand mit zweiter Datenrate | | |
| Empfangs/Sendezustand mit erster Datenrate | | |
| Frequenzwechsel-Zustand | | |
| inaktiver Zustand | | |
| Niederenergiemodus | 22 | |

$t_1$ $t_2$ $t_3$ $t_4$ $t_5$ $t_6$ $t_7$ $t_8$ t

Beobachtungszeitraum $\Delta t$

EP 1 664 813 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5065084 A